# EUROPÄISCHE PATENTANMELDUNG

(11) **EP 0 884 937 A2**
(43) Veröffentlichungstag der Anmeldung: **16.12.1998**
(21) Anmeldenummer: 98109720.7
(22) Anmeldetag: 28.05.1998
(51) Int. Cl.: H05K 3/40

(54) **Verfahren zur Durchkontaktierung von Leiterplatten**

(30) Priorität: 10.06.1997 DE 19724366
(71) Anmelder: DEUTSCHE THOMSON-BRANDT GMBH, 78048 Villingen-Schwenningen (DE)
(72) Erfinder: Soler, Guillaume, 38780 Pont-Evequé (FR)
(74) Vertreter: Rossmanith, Manfred

(57) **Zusammenfassung**

Die Erfindung betrifft ein Verfahren zum Beschichten der Innenwand von durchgängigen Öffnungen in einem Substrat mit einem fließfähigen Material. Dieses Verfahren ist insbesondere dazu geeignet, um zweiseitige oder mehrlagige Leiterplatten durchzukontaktieren, d.h. um elektrische Kontakte zwischen gedruckten Schaltungen herzustellen, die sich in unterschiedlichen Ebenen der Leiterplatte befinden. Bei dem erfindungsgemäßen Verfahren werden die Durchkontaktierungslöcher mit einer leitfähigen Paste bedruckt, die durch das Anlegen eines Unterdrucks in die Kontaktierungslöcher gesaugt wird.

## Beschreibung

Die Erfindung betrifft ein Verfahren zum Beschichten der Innenwand von durchgängigen Öffnungen in einem Substrat mit einem fließfähigen Material gemäß dem Oberbegriff des Anspruchs 1. Insbesondere bezieht sich die Erfindung auf ein Verfahren zum Durchkontaktieren von zwei- oder mehrlagigen Leiterplatten. Weiterhin betrifft die Erfindung eine Leiterplatte.

Aus der DE-OS 34 20 966 ist ein Siebdruckverfahren zur Durchkontaktierung von Leiterplatten bekannt. Gemäß dem bekannten Verfahren erfolgt zunächst ein ganzflächiger Auftrag einer Leitpaste auf ein Drucksieb. Hierauf wird eine Rakel über das Drucksieb gezogen und dabei elektrisch leitfähige Paste durch das Drucksieb hindurch auf die Oberfläche eines Substrates aufgebracht. Durch einen anliegenden Unterdruck wird die leitfähige Paste in Öffnungen in dem Substrat eingesaugt. Dabei werden die Innenwände der Öffnungen des Substrats mit einer Schicht der elektrisch leitfähigen Paste beschichtet. Auf diese Weise entsteht ein elektrischer Kontakt zwischen den Schaltungen auf beiden Seiten der Leiterplatte.

Bei dem bekannten Verfahren ist die Schicht der Silberleitpaste auf der bedruckten Seite der Leiterplatte relativ dünn. Die geringe Materialdicke führt beim Stromtransport von einer Seite der Leiterplatte zur anderen zu ohmschen Verlusten in diesem Bereich. Diese ohmschen Verluste erwärmen den Bereich um die Kontaktstelle herum. Bei bestimmten Anwendungen z. B. im Kraftfahrzeugbereich kann die Betriebstemperatur solcher Leiterplatten bei ungefähr 80°C bis 100 °C liegen. Eine weitere Erwärmung durch ohmsche Verluste ist daher sehr unerwünscht, denn das Kunststoffmaterial, aus dem das Substrat der Leiterplatte besteht, kann bei noch höheren Temperaturen Schaden nehmen und lokal zerstört werden.

Druckverfahren, bei denen relativ große Mengen von Silberleitpaste in die Substratöffnungen beim Druckprozeß hineingedrückt werden, haben relativ große Materialquerschnitte und scheinen auf den ersten Blick geeignet zu sein, den genannten Nachteil zu beheben. Aber durch die Dicke der Silberleitpaste bilden sich beim Trocknen Einschlüsse von flüssigen und/oder verdampften Lösungsmittelresten. Solche Inhomogenitäten der leitenden Schicht beeinflussen gleichermaßen wie die Dicke der stromführenden Schicht die Eigenschaften des Kontaktes und führen letztlich zu großen Streuungen im elektrischen Widerstand der Kontakte. Außerdem benötigen dicke Silberleitpastenschichten relativ lange Zeit zum Trocknen, was bei der Herstellung unerwünscht ist.

Ein weiterer Nachteil dieser letztgenannten Kontakte ist, daß dieses Herstellungsverfahren nicht auf mehrlagige Leiterplatten, sogenannte Multilayerleiterplatten, anwendbar ist. Bei diesen Multilayerleiterplatten befinden sich nicht nur auf den beiden Oberflächen der Leiterplatte gedruckte Schaltungen, sondern auch in deren Innerem. Da die oben genannten Hohlräume mit dem eingeschlossenen Lösungsmittel rein zufällig verteilt sind, treten sie auch mit einer bestimmten statistischen Häufigkeit dort auf, wo die inneren Leiterschichten auf die Innenwand der Substratöffnung stoßen. Es ist ohne weiteres verständlich, daß in solchen Fällen ein schlechter elektrischer Kontakt zu den innenliegenden Leiterbahnen entsteht. Solche gestörten Kontakte sind für viele praktische Anwendungen nicht tolerierbar.

Aufgabe der Erfindung ist es, ein Verfahren zu schaffen, das die oben genannten Nachteile vermeidet.

Diese Aufgabe wird durch das erfindungsgemäße Verfahren gelöst, das dadurch gekennzeichnet ist, daß auf die bedruckte Seite des Substrats ein Unterdruck einwirkt, der das noch fließfähige Material zum Teil aus der Substratöffnung zurücksaugt, wobei gleichzeitig die Substratöffnung wieder geöffnet wird.

Ein wesentlicher Gedanke der Erfindung besteht darin, die noch feuchte, d.h. fließfähige Silberleitpaste in einem zweiten Unterdruckschritt zurückzusaugen und dadurch eine möglichst gleichmäßige Verteilung des leitfähigen Materials zu sorgen. Auf diese Weise entsteht ein Kontakt aus gleichmäßig dickem und homogenem Material, der sowohl an die Leiterbahnen auf beiden Oberflächen der Leiterplatte gut angeschlossen ist als auch an die gegebenenfalls im Inneren angeordneten Leiterbahnen.

Zweckmäßigerweise wird das Verfahren so durchgeführt, daß die Leiterplatte vor dem zweiten Unterdruckschritt um 180° gewendet wird. Dieses Vorgehen beinhaltet zwar die Schwierigkeit, daß eine Leiterplatte mit noch flüssiger Leitpaste manipuliert werden muß, was naturgemäß sehr vorsichtig zu erfolgen hat, bietet aber auf seiten des apparatetechnischen Aufwandes ganz erhebliche Vorteile. Eine Arbeitsstation in der die Leitpaste zunächst in der einen Richtung und anschließend in der anderen Richtung gesaugt würde, wäre relativ kompliziert.

In Fällen, in denen bei Produktvarianten nicht alle Substratöffnungen einer Standardleiterplatte durchkontaktiert werden sollen, kann eine Selektionsplatte auf der Seite der Leiterplatte vorgesehen werden, die dem Unterdruck ausgesetzt wird. Auf diese Weise wird sichergestellt, daß Leitpaste nur dort in die Substratöffnungen eingesaugt wird, wo tatsächlich ein Kontakt entstehen soll.

Eine zweite Aufgabe der Erfindung besteht darin, eine Leiterplatte zu schaffen, bei der in verschiedenen Ebenen der Leiterplatte angeordnete Leiterbahnen auf besonders zweckmäßige Weise elektrisch miteinander verbunden sind.

Diese Aufgabe wird durch eine Leiterplatte gemäß Anspruch 7 gelöst. Diese Leiterplatte zeichnet sich durch eine kostengünstige Herstellung sowie eine hohe Stromtragfähigkeit der Kontakte zwischen den Leiterbahnen aus, die in unterschiedlichen Ebenen der Leiterplatte angeordnet sind. Besonders vorteilhaft ist es, wenn als Leiterplatte eine mehrlagige Leiterplatte verwendet wird, bei der die Leiterbahnen nicht nur auf der Ober- und der Unterseite der Leiterplatte angeordnet sind, sondern auch in wenigstens einer Ebene dazwischen.

In der Zeichnung sind eine Vorrichtung zur Durchführung des erfindungsgemäßen Verfahrens, mehrere Verfahrensschritte sowie ein fertiger Kontakt dargestellt. Es zeigen
- Fig. 1: eine schematische Darstellung einer Druckstation zur Durchführung des erfindungsgemäßen Verfahrens;
- Fig. 2: einen Ausschnitt aus Fig. 1 in einem anderen Maßstab,
- Fig. 3a -f: mehrere Schritte des erfindungsgemäßen Verfahrens und
- Fig. 4: einen fertigen Kontakt in einer mehrlagigen Leiterplatte.

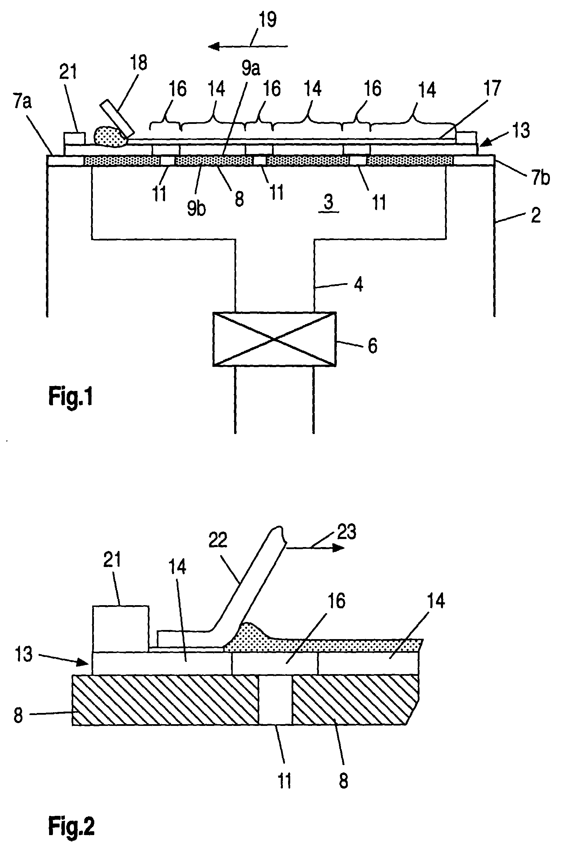

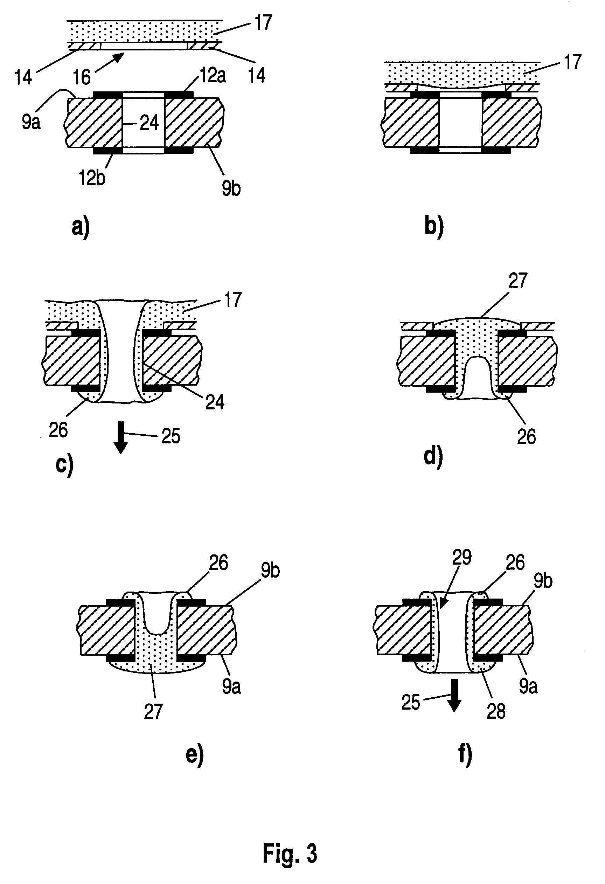

Fig. 1 zeigt schematisch eine Druckstation zur Ausführung des erfindungsgemäßen Verfahrens. Die Druckstation 1 umfaßt eine Grundplatte 2, die eine mittige Ausnehmung 3 aufweist. In die Ausnehmung 3 mündet eine Rohrleitung 4 mit großem Querschnitt, die zur einer nicht dargestellten Vakuumpumpe führt. In der Rohrleitung 4 ist zwischen der Ausnehmung 3 und der Vakuumpumpe ein steuerbares Ventil 6 angeordnet, mittels dessen die strömungsmäßige Verbindung zwischen der Ausnehmung 3 und der Vakuumpumpe hergestellt bzw. unterbrochen werden kann. Auf der Oberseite der Grundplatte 2 sind zwei verstellbare Fixierelemente 7a, 7b angeordnet. Die Fixierelemente 7a, 7b sind so eingestellt, daß eine zu bedruckende Leiterplatte 8 nahezu spielfrei zwischen die Fixierelemente 7a, 7b einlegbar ist, wobei die Oberseiten der Leiterplatte 8 und der Fixierelemente 7a, 7b im wesentlichen bündig sind. Die Leiterplatte 8 trägt sowohl auf ihrer Oberseite 9a als auch auf ihrer Unterseite 9b Leiterbahnen von gedruckten Schaltungen. In der Leiterplatte 8 sind an den Stellen, wo eine elektrische Verbindung von der Oberseite 9a zu der Unterseite 9b hergestellt werden soll, Öffnungen 11 vorgesehen. Die Ränder der Öffnungen 11 sind von jeweils einer Kontaktierungsfläche 12a bzw. 12b (Fig. 3) umschlossen, die jeweils an eine Leiterbahn der betreffenden Schaltung angeschlossen sind. Die Kontaktierungsflächen 12a, 12b sowie die Leiterbahnen bestehen aus Kupfer, können aber auch aus jedem anderen leitfähigen Material hergestellt sein, insbesondere auch mittels eines Druckverfahrens.

In Fig. 1 ist ein Drucksieb 13 auf die Leiterplatte 8 abgesenkt. Das Drucksieb 13 weist undurchlässige Bereiche 14 und durchlässige Bereiche 16 auf, wobei sich die durchlässigen Bereiche in der Arbeitsstellung der Druckstation 1 jeweils über einer Öffnung 11 in der Leiterplatte 8 befinden. Auf der Oberseite des Drucksiebes 13 ist eine Schicht 17 aus Silberleitpaste gleichmäßig verteilt. Diese Schicht 17 wird durch die Bewegung einer Flutrakel 18 über das Drucksieb 13 in Pfeilrichtung 19 erzeugt. Die Flutrakel 18 hält einen bestimmten Abstand zu der Oberfläche des Drucksiebes 13 ein, so daß einerseits die Schicht 17 eine gleichmäßige Dicke aufweist, aber andererseits keine Silberleitpaste durch die durchlässigen Bereiche 16 gedrückt wird. Der Siebrahmen 21 des Drucksiebes 13 verhindert, daß Silberleitpaste von dem Drucksieb 13 herabtropfen kann.

Fig. 2 veranschaulicht einen Ausschnitt aus Fig. 1 und zeigt eine in Fig. 1 nicht dargestellte Druckrakel 22. Nachdem von der Flutrakel 18 eine gleichmäßige Schicht von Silberleitpaste auf dem Drucksieb 13 erzeugt worden ist, wird die Druckrakel 22 in Pfeilrichtung 23 über das Drucksieb 13 bewegt, um die Silberleitpaste durch die durchlässigen Bereiche 16 des Drucksiebes hindurchzudrücken und überschüssige Silberleitpaste von dem Drucksieb 13 abzustreifen.

Die insoweit beschriebene Vorrichtung funktioniert folgendermaßen:

In einer Produktionslinie wird eine Leiterplatte durch geeignete Fördermittel, z. B. einen Bandförderer, an die Druckstation 1 herangeführt. Ein Vakuumgreifer ergreift die Leiterplatte und legt sie in die in Fig. 1 dargestellte Arbeitsposition in der Druckstation 1 ab, wo die Lage der Leiterplatte 8 durch optische Meßmittel kontrolliert und gegebenenfalls nachkorrigiert wird.

Wahlweise kann auch eine Magazinstation vorgesehen sein, in welcher die Leiterplatten zwischengelagert werden, bevor sie in die Druckstation gelangen. Das hat den Vorteil, daß bei kurzen Unterbrechungen in der Leiterplattenzufuhr die Druckstation ohne Unterbrechung weiterarbeiten kann.

Sobald die Leiterplatte fixiert ist, wird das Drucksieb 13 eingeschwenkt. Auf dem Drucksieb 13 befindet sich ein bestimmte Menge Silberleitpaste, die durch die Bewegung der Flutrakel 18 zu einer gleichmäßig dicken, geschlossenen Schicht 17 auf dem Drucksieb verteilt wird, so daß sich die in Fig. 3a dargestellte Situation einstellt.

In einem nächsten Arbeitsschritt wird das Drucksieb 13 auf die Leiterplatte 8 abgesenkt und mit der Oberfläche 9a der Leiterplatte 8 in Berührung gebracht. Die Viskosität der Silberleitpaste ist so eingestellt, daß durch die durchlässigen Bereiche 16 des Drucksiebes 13 keine Silberleitpaste hindurchdringt.

Im folgenden Schritt wird das Ventil 6 der Druckstation 1 geöffnet, wodurch ein Unterdruck von weniger als 200 mbar Absolutdruck auf die Unterseite 9b der Leiterplatte 8 während einer Zeitdauer im Sekundenbereich einwirkt und die Silberleitpastenschicht 17 durch die Substratöffnungen 11 einsaugt, wie es in Fig. 3c dargestellt ist. Mit einem Pfeil 25 ist die Richtung des Druckgefälles angedeutet. Beim Einsaugen der Silberleitpaste durch die Öffnungen 11 wird deren Innenwand 24 von der Silberleitpaste benetzt. Die Fließeigenschaften der Silberleitpaste sind so gewählt, daß diese bevorzugt in horizontaler Richtung fließt. Das führt dazu, daß sich auf der Unterseite 9b der Leiterplatte 8 am Rand der Öffnung 11 ein Wulst 26 aus Silberleitpaste ausbildet.

In einem nächsten Verfahrensschritt (Fig. 3d) wird die Druckrakel 22 über das Drucksieb 13 bewegt. Dabei wird die Kontaktierungsfläche 12a mit Silberleitpaste bedruckt, die gleichzeitig in die Öffnungen 11 hineingedrückt wird. Darüber hinaus wird die überschüssige Silberleitpaste von der Druckrakel 22 von dem Drucksieb 13 abgestreift wie aus Fig. 3d ersichtlich ist. Die mittels der Druckrakel 22 zusätzlich in die Öffnung 11 hineingedrückte Silberleitpaste verschließt diese und bildet dort einen Pfropfen 27.

In einem anschließenden Schritt wird das Drucksieb 13 von der Leiterplatte 8 abgehoben und aus der Druckstation 1 herausgeschwenkt. Die bedruckte Leiterplatte wird von einem nicht dargestellten Vakuumgreifer um 180° gewendet und in einer der Druckstation 1 benachbarten Bearbeitungsstation abgelegt. Diese Bearbeitungsstation ist im wesentlichen wie die Druckstation aufgebaut, weist jedoch nicht die für das Bedrucken erforderlichen Einrichtungen auf. Die Leiterplatte 8 mit der noch nicht getrockneten, d.h. noch fließfähigen Silberleitpaste nimmt in der Bearbeitungsstation die in Fig. 3e dargestellte Stellung ein.

Auf die Leiterplatte wird auf deren bedruckte Seite erneut ein Unterdruck während einer im Sekundenbereich liegenden Zeitspanne angewendet und die Silberleitpaste zurückgesaugt (Fig. 3f). Der Druck beträgt in diesem Fall z.B. unter 100 mbar, wobei die Richtung des Druckgefälles wieder durch den Pfeil 25 angezeigt ist. Bei diesem Schritt öffnet sich der Pfropfen 27 aus Silberleitpaste, und es entsteht eine offene Hülse 29. Die Silberleitpaste die zuvor den Pfropfen 27 gebildet hat verteilt sich dabei insbesondere auf der Seite 9a der Leiterplatte und bildet dort einen Wulst 28 aus, dessen Abmessungen mit denen des Wulstes 26 vergleichbar sind. Auf diese Weise wird erreicht, daß die dünnste Querschnittsfläche der leitenden Hülse 29 insgesamt zunimmt und dadurch die Stromtragfähigkeit des so gebildeten Kontaktes wesentlich erhöht wird. Die Schichtdicke der leitenden Hülse 29 beträgt z.B. wenigstens 10 µm.

Da es keinen Zwischentrocknungsschritt gibt, ist die so entstehende Schicht aus Silberleitpaste vollkommen homogen und weist einen sehr geringen elektrischen Widerstand von unter 15 mOhm auf. Im Vergleich zu einer geschlossenen Hülse ist die Schichtdicke der Hülse 29 wesentlich geringer, so daß auch eine wesentlich kürzere Trocknungszeit erzielbar ist. Das hat den Vorteil, daß die schädlichen Einflüsse von Temperaturschwankungen auf die Herstellungsgenauigkeit durch Längenausdehnung reduziert werden kann. Gegenüber einen geschlossenen Hülse hat die vorliegende offene Hülse 29 auch den Vorteil, daß im Betrieb der Leiterplatte durch Konvektion eine gewisse Kühlwirkung erzielt wird.

Unabhängig davon, ob eine offene oder geschlossene Hülse vorliegt, bereitet die Längenausdehnung senkrecht zu den Oberflächen 9a, 9b der Leiterplatte 8, d.h. koaxial zur Längsachse der leitenden Hülse besondere Schwierigkeiten. Sobald die Hülse so weit getrocknet ist, daß sie nicht mehr flexibel ist, entstehen bei jeder weiteren Längenausdehnung in der genannten Richtung Risse in der Hülse, die sich schädlich auf die elektrische Leitfähigkeit bzw. auf die Stromtragfähigkeit des Kontaktes auswirken. Bei der Erfindung treten wegen der kurzen Trocknungszeit derartige Risse nicht mehr auf.

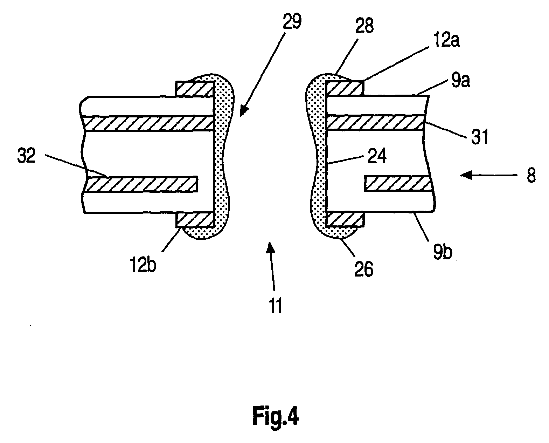

Das erfindungsgemäße Verfahren ist ohne Änderung auch auf sogenannte Multilayerleiterplatten anwendbar, bei denen sich nicht nur auf den beiden Oberflächen der Leiterplatte gedruckte Schaltungen befinden, sondern auch in deren Innerem. Fig. 4 zeigt einen Ausschnitt aus einer solchen Leiterplatte mit einer Kontaktierungsöffnung. Im folgenden werden für entsprechende Elemente die selben Bezugszeichen wie in Fig. 3 verwendet.

Zwischen den beiden auf den Oberflächen 9a, 9b der Leiterplatte 8 angeordneten Kontaktierungsflächen 12a, 12b liegen Leiterbahnen 31, 32 in unterschiedlichen Ebenen der Leiterplatte 8. Die Leiterbahn 32 springt von der Innenwand 24 der Öffnung 11 zurück, so daß die Hülse 29 keinen elektrischen Kontakt zu der Leiterbahn 32 herstellt. Für eine gute Kontaktierung der im Inneren liegenden Leiterbahnen kommt es vor allem darauf an, daß in den Kontaktierungsöffnungen 11 die Silberleitschicht vollkommen gleichmäßig ist, wie es mit dem erfindungsgemäßen Verfahren erzielt wird.

Das erfindungsgemäße Verfahren ist auch auf mehrlagige Leiterplatten anwendbar, die mehr oder weniger Lagen als in Fig. 4 dargestellt sind, aufweisen. Durch das Weglassen von Kontaktierungsflächen 12a oder 12b, bzw. das Zurückspringen von inneren Leiterbahnen von der Innenwand 24 der Öffnung 11 können mit dem erfindungsgemäßen Durchkontaktierungsverfahren elektrische Kontakte zwischen den Leiterbahnen in jeder beliebigen Kombination hergestellt werden.

In den Fällen, in denen nicht alle Öffnungen 11 der Leiterplatte 8 durchkontaktiert werden sollen, wird in der Druckstation 1 sowie der Bearbeitungsstation eine sogenannte Selektionsplatte vorgesehen, die an der Unterseite der Leiterplatte 8 anliegt und durchgängige Öffnungen unterhalb derjenigen Öffnungen 11 in der Leiterplatte enthält, die durchkontaktiert werden sollen. An allen übrigen Stellen ist die Selektionsplatte geschlossen und verhindert, daß der Unterdruck auf undurchlässige Bereiche 14 des Drucksiebes 13 einwirkt. Auf diese Weise ist sichergestellt, daß die Silberleitpaste nur in die Öffnungen 11 eingesaugt wird, in denen tatsächlich ein Kontakt hergestellt werden soll. Diese Selektionsplatte wird bei dem Zurücksaugen der Silberleitpaste nicht verwendet.

Obwohl in der obenstehenden Beschreibung stets auf Silberleitpaste Bezug genommen wird, ist die Erfindung nicht darauf beschränkt. Es können auch andere leitfähige Pasten zur Anwendung kommen, z.B. Karbonpasten.

## Patentansprüche

1. Verfahren zum Beschichten der Innenwand (24) von durchgängigen Öffnungen (11) in einem Substrat (8) mit einem fließfähigen Material, wobei das Verfahren die Schritte aufweist:
a) das Substrat (8), das wenigstens eine durchgängige Substratöffnung (11) aufweist, wird positioniert und anschließend fixiert;
b) auf einem Drucksieb (13) wird das fließfähige Material gleichmäßig verteilt;
c) das Drucksieb (13) wird auf das Substrat (8) abgesenkt;
d) auf die von dem Drucksieb (13) abgewandte Seite (9b) des Substrates (8) wirkt ein Unterdruck ein, der das fließfähige Material in die Substratöffnungen (11) in der Weise einsaugt, daß die Innenwand (24) der Substratöffnung benetzt wird;
e) ein bewegbares Element (22) wird über das Drucksieb bewegt, so daß das fließfähige Material in die Substratöffnung (11) gedrückt wird und diese zumindest teilweise füllt und die durchgängige Substratöffnung (11) verschließt; **dadurch gekennzeichnet**, **daß**
f) auf die bedruckte Seite (9a) des Substrats (8) ein Unterdruck einwirkt, der das noch fließfähige Material zum Teil aus der Substratöffnung (11) zurücksaugt, wobei gleichzeitig die Substratöffnung (11) wieder geöffnet wird.

2. Verfahren nach Anspruch 1, **dadurch gekennzeichnet**, daß die Positionierung des Substrates optisch kontrolliert und gegebenenfalls nachkorrigiert wird.

3. Verfahren nach Anspruch 1, **dadurch gekennzeichnet**, daß das Substrat (8) vor dem letzten Saugschritt um 180° gedreht wird.

4. Verfahren nach Anspruch 1, **dadurch gekennzeichnet**, daß als Substrat eine zweiseitige Leiterplatte (8) verwendet wird.

5. Verfahren nach Anspruch 1, **dadurch gekennzeichnet**, daß als Substrat eine mehrlagige Leiterplatte (8) verwendet wird.

6. Verfahren nach Anspruch 1, **dadurch gekennzeichnet**, daß auf der von dem Drucksieb abliegenden Seite (9b) des Substrats (8) eine Selektionsplatte vorgesehen wird, die eine Anzahl von Öffnungen aufweist, die an den entsprechenden Stellen wie die Substratöffnungen (11) angeordnet sind.

7. Leiterplatte (8) mit Leiterbahnen (12a, 12b, 31, 32), die auf wenigstens zwei unterschiedlichen Ebenen der Leiterplatte angeordnet sind, **dadurch gekennzeichnet**, daß die Leiterplatte an wenigstens einer Stelle (11) eine Verbindung aufweist, die nach einem Verfahren gemäß der Ansprüche 1 bis 6 hergestellt ist.

8. Leiterplatte nach Anspruch 7, **dadurch gekennzeichnet**, daß wenigstens eine Leiterbahn (31, 32) in einer Ebene verläuft, die sich zwischen der Oberseite (9a) und der Unterseite (9b) der Leiterplatte (8) erstreckt.
